# EUROPEAN PATENT APPLICATION

(11) **EP 4 845 310 A1**
(43) Date of publication of application: **25.11.2026**
(21) Application number: 26179523.1
(22) Date of filing: 19.05.2026
(51) Int. Cl.: H05H 1/46, H01J 37/32

(54) **INCA PLASMA SOURCE**

(30) Priority: 21.05.2025 EP 25177934
(71) Applicant: Plasmetrex GmbH, 12489 Berlin (DE)
(72) Inventor: Klick, Michael, 16348 Wandlitz (DE)
(74) Representative: Kandlbinder, Markus Christian

(57) **Abstract**

The invention relates to an INCA plasma source with at least one coil array of at least two excitation coils (10, 12, 14) that are electrically connected in series with each other, wherein each excitation coil (10, 12, 14) includes an input terminal (16) and an output terminal (18). The electrical connection between at least two neighboring coils (10, 12, 14) includes at least one first electrical capacitor (20) that electrically connects the output terminal (18) of one of the neighboring coils with the input terminal (16) of the other of the two neighboring coils (10, 12, 14).

## Description

The present invention relates to an INCA plasma source with at least one coil array of at least two excitation coils that are electrically connected in series with each other, wherein each excitation coil includes an input terminal and an output terminal, according to the preamble of claim 1.

An INCA (Inductively Coupled Non-thermal Atmospheric) plasma source is designed to generate plasma efficiently at atmospheric pressure using inductive coupling (Inductively Coupled Plasma - ICP). It typically consists of the following key components: a power supply, a high-frequency generator, an inductive coil (Antenna / Excitation Coil), a gas inlet system, a plasma discharge region, a cooling system (Optional) and an output nozzle (if applicable). The plasma source requires a radio frequency (RF) generator (typically in the range of MHz frequencies).

The generator provides energy to ionize the working gas and sustain the plasma. A matching network for impedance matching is usually needed to optimize energy transfer and minimize power losses.

A helical or planar coil is placed around or near the discharge region. This coil carries alternating current (AC), generating a time-varying magnetic field (B). The changing magnetic field induces an electric field (E), which accelerates free electrons, leading to gas ionization and plasma formation.

The INCA plasma source operates with various gases, preferably reactive gases (e.g., Ar, SF₆, F₂, NF₃ od O₂). The gas is introduced into the discharge region through precisely controlled gas flow channels. Some setups allow for additional reactive gases to modify plasma properties for specific applications.

The plasma is generated inside a dielectric chamber (e.g., quartz or ceramic) to prevent etching or contamination of the coils. The plasma may form in an open jet or be confined inside a process chamber, depending on the application. The non-thermal nature of the plasma means that electron temperatures are high, while the overall gas temperature remains relatively low (suitable for material processing or biomedical applications).

Since high-frequency RF power generates heat, some INCA plasma sources include a water-cooled or air-cooled system. This prevents overheating and ensures stable plasma operation over extended periods.

In some designs, the plasma is ejected through a nozzle to form a plasma jet. The nozzle may control the plasma expansion and direct the flow towards a target surface.

The major disadvantage of these INCA plasma sources is the additional capacitive coupling through the electric field of the coils, increasing with number, operating frequency, and inductance of the coils. This leads also to sputtering at the coupling plate and limits the scalability. For the setup an RF matchbox for impedance matching is required.

The INCA plasma sources setup provides an additional heating mechanism for electrons which improves the process performance at lower pressure < 2 Pa. The single INCA coils are typically small, with a diameter of some cm. The magnetic and so the induced electric field decays with a distance exceeding the coil radius. Therefore, the coil must be located very close to the coupling plate or dielectric window and the coupling plate has to be thin, e.g. some mm. Due the voltage drop over the coil and due to its inductance, there is a strong capacitive coupling (via the electric field). This electric field leads to an increase of the energy of the plasma ions hitting the coupling plate. This leads to sputtering at the coupling plate, usually made of ceramics or quartz, that reduces the lifetime of the plate and, more important, to an undesired deposition of the plate materials at the surface of the substrate to be treated which scavenges all the benefits acquired with the INCA concept.

One noticeable improvement of the performance, mainly targeting the scalability and homogeneity of the plasma, is the usage of an inductively coupled array or string or line of coils that are electrically connected in series and which presents the advantages of preserving the homogeneity of the plasma by up scaling the plasma volume. Such plasma sources are known e.g. from U. Czarnetzki and Kh. Tarnev, "Collisionless electron heating in periodic arrays of inductively coupled plasmas" in Physics of Plasmas 21, 123508, (2014), U. Czarnetzki, "Kinetic model for stochastic heating in the INCA discharge" in Plasma Sources Sci. Technol. 27, 105011, (2018); P. Ahr et al, "Inductively coupled array (INCA) discharge" in Plasma Sources Sci. Technol. 27 105010, (2018); and P. Ahr, PhD, "Investigation of an efficient stochastic electron heating mechanism in periodically structured vortex fields" at the Faculty for Physics and Astronomy at the Ruhr University Bochum, Germany (2019).

However, if the coils are operated without an adequate protection circuit, large amounts of energy can be coupled to the plasma media through capacitively coupling which in return scavenges all the benefits acquired with the INCA concept.

The object of the invention is to improve an INCA plasma source such that a better scalability with at the same time high homogeneity of the plasma is achieved.

This object is solved by an INCA plasma source of the above type with the features characterized in claim 1. Advantageous further developments of the invention are specified in the dependent claims.

According to the invention the INCA plasma source of the above type is characterized in that the electrical connection between at least two neighboring coils includes at least one first electrical capacitor that electrically connects the output terminal of one of the neighboring coils with the input terminal of the other of the two neighboring coils.

This has the advantage that the E-Field at the location of the plasma is locally reduced and thus capacitively coupling and sputtering at the coupling plate is prevented.

In a preferred embodiment, a first excitation coil of the coil array, which has a neighboring coil only at its output terminal side, is electrically connected with its input terminal to a radio-frequency (RF) generator via a matchbox for impedance matching via at least one second electric capacitor.

In a preferred embodiment at least one second electric capacitor has a capacitance of 300 pF.

A further reduction in capacitive coupling is achieved by the feature that a last excitation coil of the coil array, which has a neighboring coil only at its input terminal side, is connected with its output terminal to ground via at least one third electric capacitor.

In a preferred embodiment at least one of the third electric capacitor has a capacitance of 600 pF.

For a further improved reduction in capacitive coupling at least one of the third electric capacitance C₀ has half absolute value of impedance of a first or a last excitation coil of the coil array, which has only one neighboring coil, respectively.

For a further improved reduction in capacitive coupling at least one of the first electrical capacitor has a capacitance value of about half the capacitance value of the third electric capacitance C₀.

In a preferred embodiment at least one of the excitation coils is a helical or planar coil having only one, two or more windings.

In a preferred embodiment at least one of the excitation coils is a stack of two or more helical or planar coils in series or a stack of two or more helical or planar coils each of them with only one winding connected in series.

For a further reduction of the mean potential of a lower winding close to a dielectric coupling plate inside the INCA plasma source leading to reduced sputter effects at the plasma side at least one of the excitation coils is a cylinder coil, wherein each cylindrical excitation coil has a first axial end facing a dielectric coupling plate, wherein a lower winding of the cylindrical excitation coil is a last winding at the first axial end of the cylindrical excitation coil, wherein the output terminal of each cylindrical excitation coil is located at the lower winding.

For further reduced sputter effects at the plasma side an axial length of each cylindrical excitation coil is below a radius of the cylindrical excitation coil and/or the cylindrical excitation coil has only two or three windings.

A low potential or a virtual ground is created between coil and capacitor that suppresses high E-Field in the plasma is achieved by the feature that at least one of the first electrical capacitors is dimensioned such that the voltage drop through the capacitor has exactly the opposite value of that of the neighboring excitation coils.

In a preferred embodiment each of the excitation coils has an inductance of 485 nH and each first electrical capacitor has a capacitance of 300 pF.

A destructive interference of the displacement currents from both ends of each coil is achieved by the feature that an additional electric capacitance C₀ outside the coil array is present and the additional electric capacitance C₀ has half absolute value of impedance of a first or a last excitation coil of the coil array, which has only one neighboring coil, respectively.

A further suppression of capacitively coupling by an imaginary part of the impedance being almost zero is achieved by the feature that the capacitance of at least one first electric capacitor is selected in such a way that a resonance frequency of this at least one first electric capacitor together with a neighboring excitation coil as a series resonance circuit is close to operating frequency of the radio frequency (RF) generator of the INCA plasma source.

A reduction of capacitively coupling by more than 50% is achieved by the feature that the capacitance of at least one first electric capacitor is selected in such a way that a resonance frequency of this at least one first electric capacitor together with a neighboring excitation coil as a series resonance circuit is slightly below operating frequency of the radio frequency (RF) generator of the INCA plasma source.

Consequently, the imaginary part of the impedance exceeds zero (inductive) and causes a reduced capacitive coupling. A conventional RF matchbox for an inductive load is applicable.

A reduction of capacitively coupling by more than 50% is achieved by the feature that the capacitance of at least one first electric capacitor is selected in such a way that a resonance frequency of this at least one first electric capacitor together with a neighboring excitation coil as a series resonance circuit is slightly above to operating frequency of the radio frequency (RF) generator if the INCA plasma source. Consequently, the imaginary part of the impedance is negative (inductive) and causes a reduced capacitive coupling. A conventional RF matchbox for a capacitive load is applicable.

The invention will be explained below with reference to the accompanying drawings. These drawings show in:
- Fig. 1: a preferred embodiment of an INCA plasma source according to the invention in the form of an electrical equivalent circuit diagram;
- Fig. 2: a voltage drop across a series of coils connected to properly dimensioned capacitors according to the electrical equivalent circuit diagram of Fig. 1 as a graphical representation of the imaginary part of the impedance of the excitation coils and capacitors; and
- Fig. 3: a top view of another preferred embodiment of an INCA plasma source according to the invention in a schematic representation.

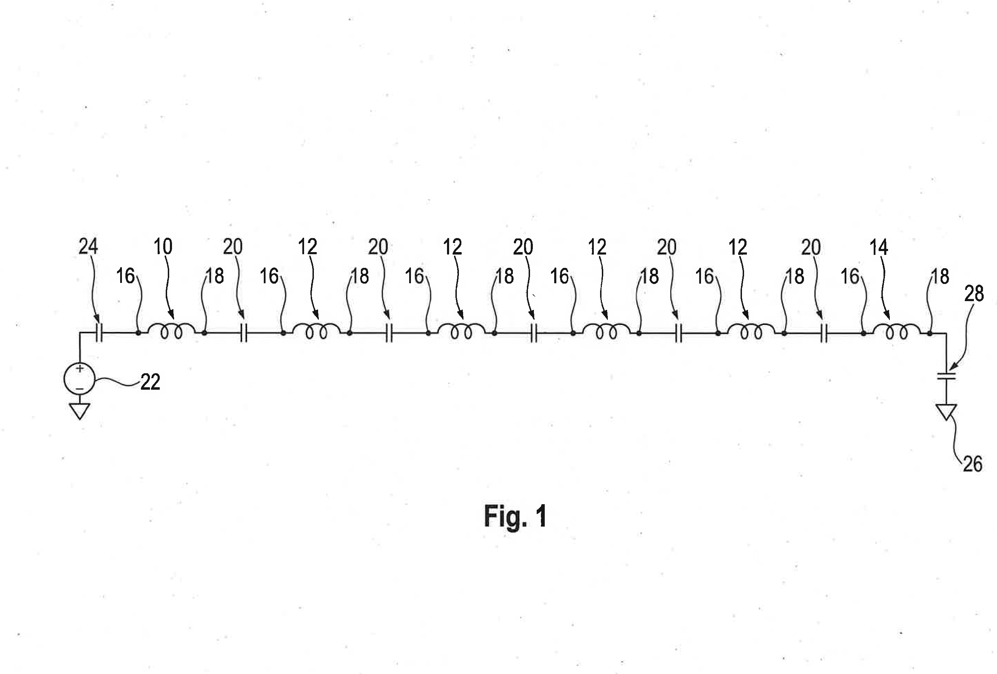

As shown in the electrical equivalent circuit diagram of Fig. 1, a preferred embodiment of the INCA plasma source according to the invention includes an array, string or line of excitation coils 10, 12 and 14 that are electrically connected in series with each other, wherein each excitation coil 10, 12 and 14 includes an input terminal 16 and an output terminal 18. In the preferred embodiment the array of excitation coils includes six excitation coils 10, 12 and 14. Four excitation coils 12 have two neighboring coils, a first excitation coil 10 of the array of excitation coils has only one neighboring coil 12 at its output terminal 18 side and a last excitation coil 14 of the array of excitation coils has only one neighboring coil 12 at its input terminal 16 side.

The electrical connection between two neighboring coils 12 includes one first electrical capacitor 20 that electrically connects the output terminal 18 of one of the neighboring coils 12 with the input terminal 16 of the other of the two neighboring coils 12. Furthermore, the output terminal 18 of the first excitation coil 10 is electrically connected to the input terminal 16 of a neighboring coil 12 with a first electrical capacitor 20. In the same way the input terminal 16 of the last excitation coil 14 is electrically connected to the output terminal 16 of a neighboring coil 12 with a first electrical capacitor 20.

The input terminal 16 of the first excitation coil 10 of the array of excitation coils is connected to a radio frequency (RF) generator 22 via at least one second electric capacitor 24. This second electric capacitor 24 is only optional and can be omitted. The output terminal 18 of the last excitation coil 14 of the array of excitation coils is connected to ground 26 via at least one third electric capacitor 28.

The INCA plasma source according to the invention is not limited to one array, string or line of excitation coils, as shown in Fig. 1, but can include two or more arrays of excitation coils which are arranged in parallel to each other. All input terminals 16 of each first excitation coil 10 of each array of excitation coils are connected to the radio frequency (RF) generator 22 directly or via at least one second electric capacitor 24. All output terminals 18 of each last excitation coil 14 of each array of excitation coils are connected to ground 26 via at least one third electric capacitor 28.

In an exemplary preferred embodiment, with coil size and assembly design as shown in Fig. 1, with an excitation frequency of 13,56 MHz each excitation coil 10, 12, 14 has an inductance of 485 nH, each first electrical capacitor 20 has a capacitance of 300 pF, the second electric capacitor 24 is omitted or has a capacitance of 300 pF and the third electric capacitor 28 has a capacitance of 600pF.

The RF Current running from the generator 22 to ground 26 through the excitation coils 10, 12, 14 generates a B-Field and an E-Field in a plasma media below a dielectric window (not shown) whose energy is transmitted to the free electrons in the plasma.

In the optimized configuration according to the present invention, each excitation coil 10, 12, 14 is electrically connected to a series capacitor 20. The electric capacitors 20 are dimensioned such that the voltage drop through the electric capacitor 20 has exactly the opposite value of that of the allocated excitation coil 10, 12, 14, respectively. In this way, a low potential or a virtual ground is created between coil 10, 12, 14 and capacitor 20 that suppresses high E-Field in the plasma, because of the series resonance.

With the operating frequency f_{res,k} of the k-th series connection of one electric capacitor 20 with one excitation coil 10, 12, 14 the general equations of resonance frequency and impedance is written as: ${f}_{res , k} = \frac{1}{2 π \sqrt{{L}_{k} {C}_{k}}} with k ∈ ℕ ∧ k \neq 0$ with Lₖ is the inductance of the k-th excitation coil and Cₖ is the capacitance of the k-th electric capacitor.

The impedance Z_{α} in each array α of excitation coils 10, 12, 14, with m coils results in ${{Z}_{_}}_{α} = {\sum }_{k = 1}^{m} \left[j\left({ωL}_{α}^{k}-\frac{1}{{ωC}_{α}^{k}}\right)\right] + j \left({ωL}_{0}-\frac{1}{{ωC}_{0}}\right) =$ $= {\sum }_{k = 1}^{m} \left[j2{πfL}_{α}^{k}\left(1-\frac{{f}_{res , k}^{2}}{{f}^{2}}\right)\right] + j \left({ωL}_{0}-\frac{1}{{ωC}_{0}}\right)$ with $α , m ∈ ℕ$ *and α, m* ≥ 1 *and* ${C}_{0} = \frac{2}{{ω}^{2} \frac{{L}_{0}}{n}} = \frac{2 n}{{ω}^{2} {L}_{0}}$ is the capacitance of the third electrical capacitor 28 with n being the number of windings of the last excitation coil 14, ${L}_{α}^{k}$ is the inductance of the k-th excitation coil 10, 12 in the array α of excitation coils, ${C}_{α}^{k}$ is the capacitance of the k-th electric capacitor 20 in the array α of excitation coils, $f = \frac{ω}{2 π}$ is the operating frequency of the RF generator and L₀ is the inductance of the last excitation coil 14. Usually, L₀ and all the ${L}_{α}^{k}$ of one array α of excitation coils are essentially equal. All ${L}_{α}^{k}$ of all arrays α of excitation coils may be equal. In a minimum arrangement there are no excitation coils 12 present and only excitation coils 10 and 14 with one electrical capacitance 20 and one electrical capacitance 28 form one complete coil array α of excitation coils. In this case in the formular above m is equal to 1 for each array α of excitation coils. The last two terms $j \left({ωL}_{0}-\frac{1}{{ωC}_{0}}\right)$ are not part of the sum and correspond to the last series connection of last excitation coil 14 and third electrical capacitor 28.

Total impedance *Zₜₒₜ* including all arrays, strings or lines of excitation coils 10, 12, 14 yields then to ${{Z}_{_}}_{tot} = \frac{1}{{\sum }_{α} \frac{1}{{{Z}_{_}}_{α}}} with α ∈ ℕ ∧ α \geq 1$

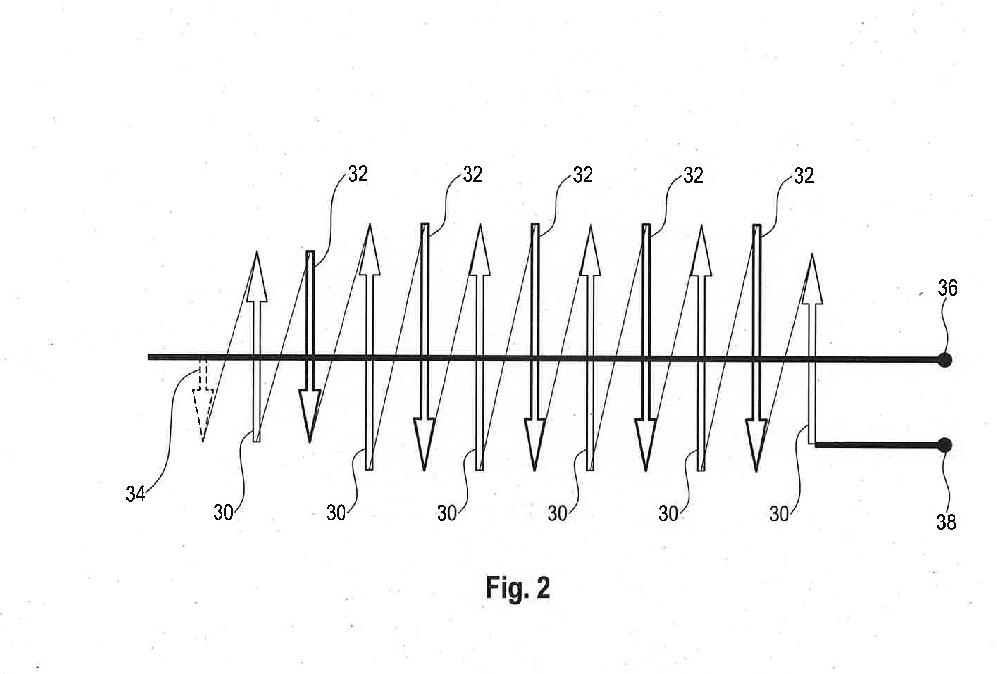

Fig. 2 shows the voltage drops across the array of excitation coils 10, 12, 14 connected to properly dimensioned capacitors 20 according to the embodiment of the invention as shown in Fig. 1. The embodiment according to Fig. 1 has six excitation coils 10, 12, 14 and six electric capacitors 20 in series. The real part of the impedance is not shown in Fig. 2. Arrows 30 show the voltage drop of excitation coils k. Arrows 32 show the voltage drop of electric capacitors k. The arrow 34 shows the voltage drop of the third capacitor 28. The arrows indicate the sign of the imaginary part of the impedance of each element. Line 36 shows the electrical connection to ground potential and line 38 shows the electrical connection to a RF matchbox (not shown) for electrical connection to the radio frequency (RF) generator 22.

The minimum coupling of the electric field is achieved, as shown in Fig. 2, if the third capacitor 28 has half absolute value of impedance of the next coil, that means 28 must have approximately the twice capacitance of the other capacitors. This results in a destructive interference of the displacement currents from both ends of each coil.

The outer excitation coils 10, 14 suffer from a symmetry break at the array edge due to the cross-talk between the excitation coils. Depending on the setup (para or ortho array), the voltage drop of the outer excitation coils 10, 14 can be higher or lower than that of the inner excitation coils 12. This can be compensated by adjusting the capacitance of the corresponding capacitors as shown in Fig. 2.

The dimensioning of the capacitors 20, 24, 28 for the coils shell also take into account, that inductance of the coils is slightly decreased when the plasma is present as load. The capacitors shell has always a slightly higher value than the value calculated for the coils 10, 12, 14 without any load.

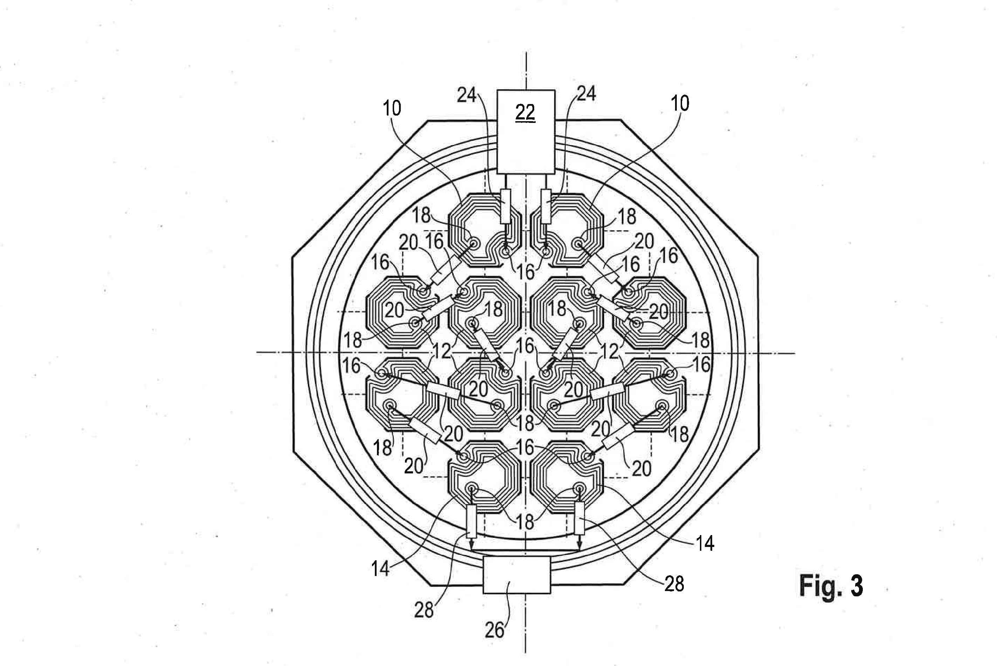

Fig. 3 shows a schematic top view of an INCA Coil Array for an INCA plasma source according to a second embodiment of the invention. In this second embodiment the INCA plasma source includes two arrays, strings or lines of excitation coils 10, 12, 14. The two arrays are not arranged in a straight line, but are folded into each other or as a zigzag line, respectively, and both arrays are arranged within a common plane. The excitation coils 10, 12, 14 of each array, string or line of excitation coils are fabricated as planar coils, respectively.

According to the present invention a series resonance is used for the INCA plasma source with one capacitor 20 for each coil 10, 12, 14 to suppress capacitively coupling as much as possible by setting the resonance frequency close to operating frequency of the radio frequency (RF) generator 22 of the INCA plasma source. Consequently, the imaginary part of the impedance is almost zero. Then a RF matchbox with an inductance, which is usually used for matching of capacitive loads, is used.

According to the invention the series resonance is used for the INCA plasma source with one capacitor 20 compensating the voltage drop of one, two of more coils 10, 12, 14. The series resonance is used for the INCA plasma source with or without an external capacitor 28. The INCA plasma source according to the invention with the series resonance may include an external coil in the connection to the RF matchbox to keep a classical matchbox for an inductive load applicable.

In order to reduce capacitively coupling by more as 50% the resonance frequency of the series resonance is set slightly below operating frequency of the radio frequency (RF) generator 22 of the INCA plasma source. Consequently, the imaginary part of the impedance exceeds zero (inductive) and causes a reduced capacitive coupling. A conventional RF matchbox for an inductive load is applicable.

In order to reduce capacitively coupling by more as 50% in a different way, the resonance frequency of the series resonance is set slightly above operating frequency of the radio frequency (RF) generator 22 of the INCA plasma source. Consequently, the imaginary part of the impedance is negative (inductive) and causes a reduced capacitive coupling. A conventional RF matchbox for an capacitive load is applicable.

In order to generate a homogeneous plasma, coils 10, 12, 14 are preferably of equal geometrical size and/or have equal electrical parameters.

In a preferred embodiment at least one of the excitation coils 10, 12, 14, preferably at least the last excitation coil 14 or all excitation coils 10, 12, 14 is a cylinder coil, wherein each cylindrical excitation coil 10, 12, 14 has a first axial end facing a dielectric coupling plate (not shown) inside the INCA plasma source. A lower winding of the cylindrical excitation coil 10, 12, 14 is a last winding at the first axial end of the cylindrical excitation coil 10, 12, 14. The output terminal 18 of each cylindrical excitation coil 10, 12, 14 is located at the lower winding.

Experimental results have shown that in order to minimize the capacitive coupling, the potential to ground of the lower winding close to the coupling plate must be low. The voltage drops over the coils are compensated approximately by the series capacitors 20 as shown in Fig.1 and causes the voltage 32 is as shown in Fig. 2. The capacitor C₀ 28 in Fig. 1 causes the voltage 34 according to Fig. 2. If the lower winding of the last coil 14 is connected with the capacitor 28, a part of the inductance of the lower winding is additionally compensated. Thus, the mean potential of the lower winding of the last coil 14 close to the dielectric coupling plate is reduced. The lower winding of the last coil 14 shows a potential close to zero (virtual ground). This is valid also for other coils 10 and 20 and the whole pattern moves down and the mean potential of the lower winding of every coil is reduced. Therefore, the capacitive coupling and sputter effcets at the plasma side are reduced. For dimensioning of the third electric capacitor 28 according to Fig. 1 the capacitance C₀ is calculated according to the formular above and should cause a voltage drop that equals approximately half the voltage drop over the lower winding of the last excitation coil 14.

## Claims

**1.** INCA plasma source with at least one coil array of at least two excitation coils (10, 12, 14) that are electrically connected in series with each other, wherein each excitation coil (10, 12, 14) includes an input terminal (16) and an output terminal (18),
**characterized in that**
the electrical connection between at least two neighboring coils (10, 12, 14) includes at least one first electrical capacitor (20) that electrically connects the output terminal (18) of one of the neighboring coils with the input terminal (16) of the other of the two neighboring coils (10, 12, 14).

**2.** INCA plasma source according to claim 1, wherein a first excitation coil (10) of the coil array, which has a neighboring coil only at its output terminal (18) side, is electrically connected with its input terminal (16) to a radio-frequency (RF) generator (22) via a matchbox for impedance matching and via at least one second electric capacitor (24).

**3.** INCA plasma source according to claim 2, wherein at least one second electric capacitor (24) has a capacitance of 300 pF.

**4.** INCA plasma source according to at least one of the preceding claims, wherein a last excitation coil (14) of the coil array, which has a neighboring coil only at its input terminal (16) side, is connected with its output terminal (18) to ground (26) via at least one third electric capacitor (28).

**5.** INCA plasma source according to claim 4, wherein the at least one third electric capacitor (28) has a capacitance of 600 pF.

**6.** INCA plasma source according to claims 4 or 5, wherein at least one of the third electric capacitance (28) has half absolute value of impedance of a first or a last excitation coil (10, 14) of the coil array, which has only one neighboring coil, respectively.

**7.** INCA plasma source according to at least one of claims 4 or 6, wherein at least one of the first electrical capacitor (20) has a capacitance value of about half the capacitance value of the third electric capacitance (28).

**8.** INCA plasma source according to at least one of the preceding claims, wherein at least one of the excitation coils (12, 12, 14) is a helical or planar coil having only one, two or more windings.

**10.** INCA plasma source according to at least one of the preceding claims, wherein at least one of the excitation coils (12, 12, 14) is a stack of two or more helical or planar coils in series or a stack of two or more helical or planar coils each of them with only one winding connected in series.

**11.** INCA plasma source according to at least one of the preceding claims, wherein at least one of the excitation coils (10, 12, 14) is a cylinder coil, wherein each cylindrical excitation coil (10, 12, 14) has a first axial end facing a dielectric coupling plate, wherein a lower winding of the cylindrical excitation coil (10, 12, 14) is a last winding at the first axial end of the cylindrical excitation coil (10, 12, 14), wherein the output terminal (18) of each cylindrical excitation coil (10, 12, 14) is located at the lower winding.

**12.** INCA plasma source according to claim 11, wherein an axial length of each cylindrical excitation coil (10, 12, 14) is below a radius of the cylindrical excitation coil (10, 12, 14).

**13.** INCA plasma source according to claim 11 or 12, wherein the cylindrical excitation coil (10, 12, 14) has only two or three windings.

**14.** INCA plasma source according to at least one of the preceding claims, wherein at least one of the first electrical capacitors (20) is dimensioned so that the voltage drop through the capacitor has exactly the opposite value of that of the neighboring excitation-coils.

**15.** INCA plasma source according to at least one of the preceding claims, wherein each of the excitation coils (10, 12, 14) has an inductance of 485 nH and each first electrical capacitor (20) has a capacitance of 300 pF.

**16.** INCA plasma source according to at least one of the preceding claims, wherein the capacitance of at least one first electric capacitor (20) is selected in such a way that a resonance frequency of this at least one first electric capacitor (20) together with a neighboring excitation coil (10, 12, 14) as a series resonance circuit is close to operating frequency of a radio frequency (RF) generator (22) of the INCA plasma source.

**17.** INCA plasma source according to at least one of the preceding claims, wherein the capacitance of at least one first electric capacitor (20) is selected in such a way that a resonance frequency of this at least one first electric capacitor (20) together with a neighboring excitation coil (10, 12, 14) as a series resonance circuit is slightly below operating frequency of a radio frequency (RF) generator (22) if the INCA plasma source.

**18.** INCA plasma source according to at least one of the preceding claims, wherein the capacitance of at least one first electric capacitor (20) is selected in such a way that a resonance frequency of this at least one first electric capacitor (20) together with a neighboring excitation coil (10, 12, 14) as a series resonance circuit is slightly above operating frequency of a radio frequency (RF) generator (22) of the INCA plasma source.
